# EUROPEAN PATENT APPLICATION

(11) **EP 1 577 942 A2**
(43) Date of publication of application: **21.09.2005**
(21) Application number: 05290559.3
(22) Date of filing: 14.03.2005
(51) Int. Cl.: H01L 21/768, H01L 27/146, H01L 31/02

(54) **Device with through-hole interconnection and method for manufacturing the same**

(30) Priority: 16.03.2004 JP 2004074325; 15.10.2004 JP 2004301919
(71) Applicant: FUJIKURA LTD., Tokyo-to (JP)
(72) Inventor: Yamamoto, Satoshi, Kohtoh-ku Tokyo (JP); Suemasu, Tatsuo, Kohtoh-ku Tokyo (JP)
(74) Representative: Burbaud, Eric

(57) **Abstract**

A device having improved electrical connection includes a first substrate (11) including a first side and a second side; a functional element (12) on the first side of the first substrate; a pad (13) that is electrically connected to the functional element; and a through-hole interconnection (15) provided in a hole extending through the first substrate from the first side to the second side, the through-hole interconnection including a first conductive material (17) and being electrically connected to the pad, and a conductive region (18) that is provided along a portion of an inner surface of the hole, and is made of a second conductive material, different from the first conductive material.

## Description

### CROSS REFERENCE TO RELATED APPLICATIONS

This application is based upon and claims the benefit of priority from Japanese Patent Application No. 2004-74325, filed March 16, 2004 and Japanese Patent Application No. 2004-301919, filed October 15, 2004, the contents of which are incorporated herein in their entirety by reference.

### BACKGROUND OF THE INVENTION

### Field of the Invention

The invention relates to a device including a through-hole interconnection electrically connecting to a functional element that has been provided on a substrate, and to a method for manufacturing the same. The invention is suitably used for a device that is provided on a substrate, for example, a light-emitting element such as a semiconductor laser, or a light receiving element such as a solid-state image sensing device, or the like, as a functional element.

### Description of Related Art

In recent years, a technique has been used in which through-hole interconnections penetrate the substrate from the one side of the substrate on which a functional element is provided toward the other side of the substrate, in order to reduce the size or increase the functionalities of electronic devices, such as ICs (integrated circuits) or LSIs (large-scale integrated circuits) or the like, or optical devices, such as OEICs (optoelectronic integrated circuits) or optical pickups or the like.

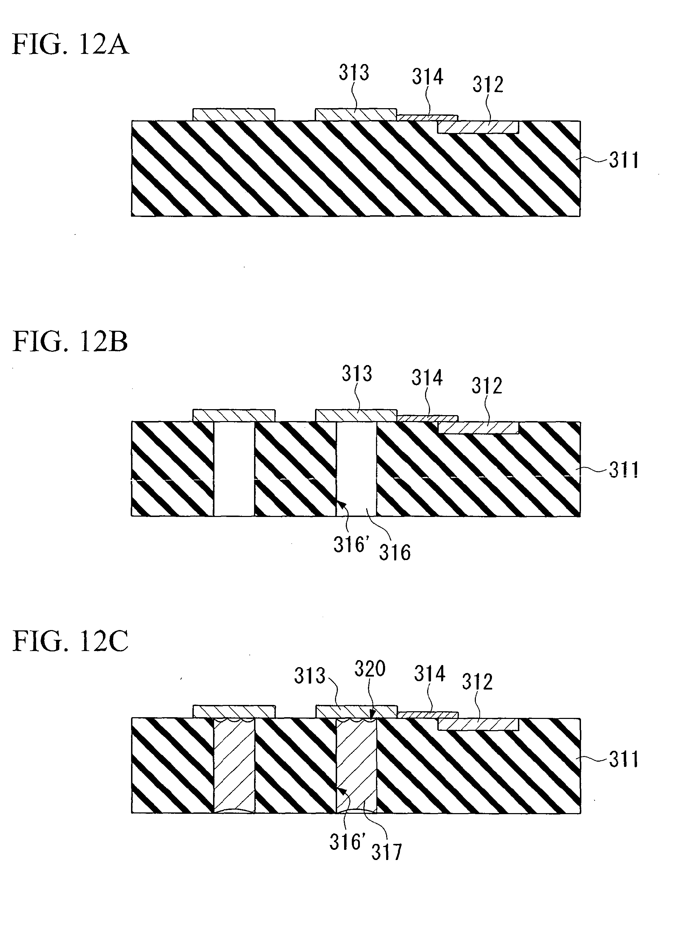

Related art methods for forming through-hole interconnections may be categorized into two methods based on in which direction a through hole is formed. FIGS. 11A to 11E are schematic cross-sectional views schematically illustrating manufacturing processes according to the first method. In the first method, small holes are formed in a substrate from a first side (front side) of the substrate on which an element has been provided toward a second side (back side). Once a conductive material is filled in the holes, then both sides of the substrate are polished to form through-hole interconnections (for example, see Unexamined Japanese Patent Application, First Publication No. 2001-351997, and 2002 ICEP Proceedings, p. 327). FIGS. 12A to 12C are schematic cross-sectional views schematically illustrating manufacturing processes according to the second method. In the second method, pads are provided on a first side of a substrate (front side) on which an element has been provided, and small holes are formed from a second side (back side) of the substrate toward the pads. Then, a conductive material is filled in those small holes to form through-hole interconnections.

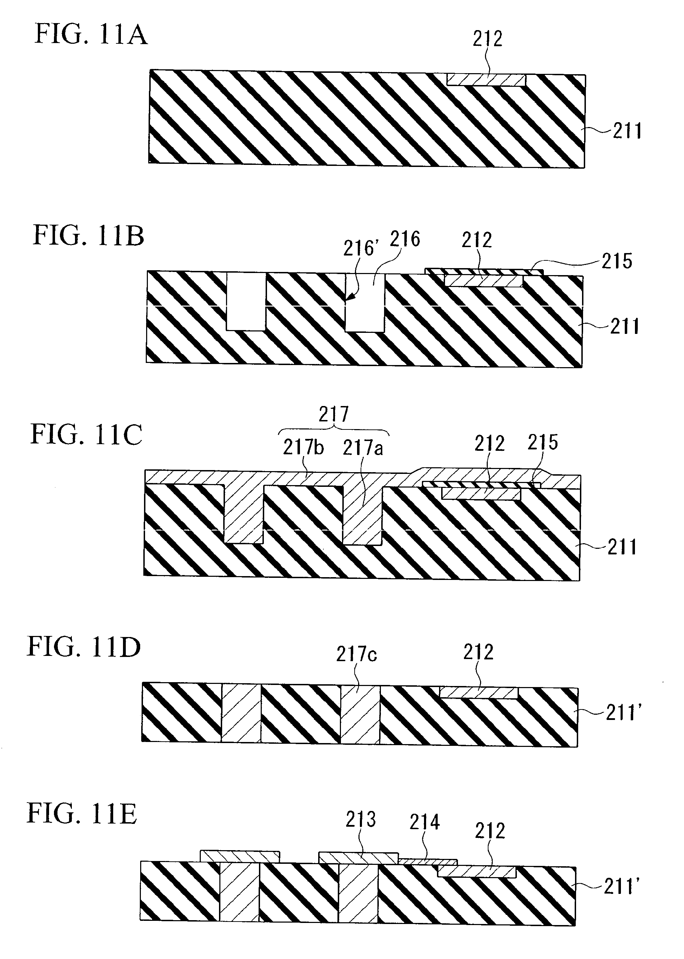

In the first method, a parallel-plate substrate 211 having a functional element 212 on a first side (the upper side in the figure) thereof, for example, is provided (FIG. 11A). Then, after a protective film 215 made of a resist or the like is provided so as to cover at least the functional element 212, cylindrical-shaped small holes (holes) 216 are formed from the first side of the substrate 211, for example (FIG. 11B). Here, reference numeral 216' denotes an inner side wall of the holes. Then, a conductive material 217 is disposed so as to cover the first side of the substrate 211 as well as to fill in the holes 216 (FIG. 11C). In the conductive material 217, the portion referred to by reference numeral 217a is a portion of the conductive material 217 filling the holes 216, and the portion referred to by reference numeral 217b is the portion of the conductive material 217 covering the first side of the substrate 211. Then, both sides of the substrate 211 are subjected to polishing so that the part of the portion 217a filling the holes 216 (hereinafter, referred to as "through-hole interconnection") 217c remains (FIG. 11D). Reference numeral 211' denotes the substrate after polishing. In the above-described processes, the through-hole interconnections 217c are obtained which penetrate through the substrate 211' from the first side to the second side (lower side in the figure). Then, after polishing, pads 213 that cover at least the through-hole interconnections 217c and electrically connect to the through-hole interconnections 217c and circuit (wiring) 214 that electrically connects between a pad 213 and the functional element 212 are provided on the first side of the substrate 211' (FIG. 11E). According to the first method, since the functional element 212 and a through-hole interconnection 217 are electrically connected by the circuit 214 and a pad 213, the functional element 212 can have an electrically connecting terminal on the second side of the substrate 211'. It should be noted that the part of the portion 217b that covered the first side of the substrate 211 may be left so in the above-described polishing step that the remaining portion can be used as circuit.

However, the first method has shortcomings as follows:

(1) In the first method, plasma processing is used to provide the holes 216 in the first side of the substrate 211. During this step, the substrate 211 and the protective film 215 are directly exposed to plasma, and are affected by heat or external forces caused by the plasma. Consequently, the functional element 212 and the substrate 211 are affected by the plasma through the substrate 211 or the protective film 215 to some extent.

In addition, the polishing process is used to form through-hole interconnections 217c such that the portion 217a of the conductive material 217 that is filled in the holes 216 is exposed to both sides of the substrate 211'. In this polishing process, the thickness of the substrate 211 is reduced to obtain the substrate 211', and the protective film 215 that covers the functional element 212 provided on the first side of the substrate is removed at the same time. As a result, the functional element 212 is subjected to some extent to the heat and external forces to which the substrate is subjected.

Such heat and external forces may affect the functions and the performances of the functional element 212.

(2) In the first method, both sides of the substrate 211 are polished to reduce the thickness of the substrate 211' to the thickness of the final product and to form the through-hole interconnections 217c that penetrate through the substrate 211' from the first side to the second side thereof. Therefore, the polishing process is indispensable in the first method, which tends to increase the device manufacturing cost.

As a solution to the shortcomings (1) and (2) of the first method, a second method was proposed by the present inventors. In the second method, it is possible to form through-hole interconnections in a substrate 311 which has been provided with a functional element 312, pads 313 and circuit (wiring) 314 on a first side thereof, and on which the functional element 312 is electrically connected to a pad 313 or electrically connected to a pad 313 via the circuit 314.

FIGS. 12A to 12C are cross-sectional views schematically illustrating manufacturing processes according to the second method. In the second method, a substrate 311 having pads 313 on a first side thereof, for example, is provided (FIG. 12A). Then, cylindrical-shaped holes 316 are formed from a second side (lower side in the figure) of the substrate 311 until the back side (the side that had been in contact with the substrate 311 before the hole was formed) of pads 313 is exposed (FIG. 12B). Here, reference numeral 316' denotes the inner side wall of the holes. Then, a conductive material 317 (hereinafter, also referred to as "through-hole interconnection") is provided to fill the holes 316 (FIG. 12C).

According to the second method, pads 313 and devices of various kinds (not shown) that are positioned between the pads and are electrically connected thereto can be provided beforehand on the first side of the substrate 311. Thus, it is possible to provide a device on the first side (the upper side in the figure) of the substrate 311 with an electrically connecting terminal on the second side of the substrate 311 by simply forming the through-hole interconnection 317. Furthermore, unlike the first method, since there is no need to polish the substrate 311 after the formation of the through-hole interconnections, no material is wasted and extra manufacturing steps can be omitted. Thus, the second method is advantageous in that it may offer cost reduction.

However, the second method has shortcomings as follows:

(1) No special treatment is performed on the inner side walls 316' of the holes 316 that have been formed from the second side of the substrate 311. Therefore, the adhesion between the filled conductive material 317 and the substrate 311 is poor. As a result, there may be a gap formed between the conductive material 317 and the inner side wall 316', or an element contained in the conductive material 317 may tend to diffuse to the substrate 311.

(2) Before filling the conductive material 317 into holes 316, the bottom of the holes 316, i.e., the back side (the side that had been in contact with the substrate 311 before the hole was formed) of the pads 313, is made exposed. For the pads 313, an aluminum-based metal is preferably used. Since an aluminum-based metal is oxidized easily, an uneven oxidized region 320 will be formed on the thus exposed surface of the metal immediately after the formation of the holes 316. As a result, the oxidized region 320 functions as an electrical barrier and may inhibit or destabilize the electrical connection between the conductive material 317 and the pads 313, which makes an improvement in the long-term reliability difficult.

Accordingly, in the second method, there is a need for a newly designed device and a method for manufacturing the same that can solve the problem of a formation of a gap, diffusion of a material, or oxidation that occurs on the sidewall 316' that is a part of the inner wall of the holes 316 or on the back side of the pads 313.

### SUMMARY OF THE INVENTION

The invention was conceived in view of the above-described background, and an object thereof is to provide a device and a method for manufacturing the same that can reduce formation of gaps, diffusion of a material, or oxidation that occur between the inner wall of holes and through-hole interconnections made of a conductive material filled in the small holes (holes), and can stabilize an electrical connection between pads and the through-hole interconnections.

A device according to a first aspect of the invention includes a first substrate including a first side and a second side; a functional element on the first side of the first substrate; a pad that is electrically connected to the functional element via the first circuit; and a through-hole interconnection provided in a hole extending through the first substrate from the first side to the second side, the through-hole interconnection including a first conductive material that is electrically connected to the pad; and a conductive region that provided at a portion of an inner surface of the hole between said first conductive material and said inner surface, and is made of a second conductive material, different from the first conductive material.

In the above-described device, the conductive region made of the second conductive material that is different from the first conductive material of the through-hole interconnection is provided on at least a portion of the inner surface of the hole, i.e., at least one of the inner side wall and the bottom of the hole. Thus, the through-hole interconnection contacts the inner surface of the hole via the conductive region where the conductive region is provided. By using a material having an excellent wettability with respect to the first conductive material as the second conductive material, the adhesion between the first substrate and the through-hole interconnection that is formed by filling the first conductive material can be enhanced. Thus, a formation of a gap between the first substrate and the first conductive material is prevented. By using a material that has an excellent diffusion barrier property (passivation) as the second conductive material, an element included in the first conductive material is prevented from diffusing to the first substrate or the pad. Thus, the deterioration of the characteristics of the device can be prevented. By using a material which is resistant to oxidation as the second conductive material, oxidation of the pad is prevented on the surface of the pad. Thus, an electrical connection between the pad and the through-hole interconnection is stabilized.

In the above-described device, the conductive region may be provided on the back side of the pad that defines a bottom of the hole.

In the above-described device, the conductive region may be made of a material that enhances adhesion between the first conductive material and the pad.

In the above-described device, the conductive region may be provided on the side wall of the hole.

In the above-described device, the first conductive material may contain at least one element, and the conductive region may prevent the at least one element contained in the first conductive material from diffusing to the first substrate.

In the above-described device, the conductive region may be provided on the back side of the pad which defines the bottom of the hole, and a side wall of the hole.

In the above-described device, the conductive region is made of a material that enhances adhesion between the inner wall of the hole and the pad.

In the above-described device, the first conductive material may contain at least one element, and the conductive region may prevent the at least one element contained in the first conductive material from diffusing to the first substrate.

In the above-described device, it may be preferable that, a circumference of a region of contact between the through-hole interconnection and the pad is within a circumference of a region of contact between the pad and the first substrate.

In the above-described device, the conductive region may include at least two layers, and the at least two layers are made of different materials.

In the above-described device, an insulating dielectric region may be formed on an inner side wall of said hole between said first conductive material and said first substrate; and the first substrate may be formed of a conductive material.

In the above-described device, the insulating dielectric region may extend from the hole at said second side of the first substrate to cover a portion of the second side of the first substrate; the conductive region may extend from the hole at the second side of the first substrate and cover a portion of the insulating dielectric region which extends from the hole; and, the through-hole interconnection may extend from the hole at the second side of the first substrate and cover a portion of the conductive region which extends from said hole.

In the above-described device, the through-hole interconnection may completely cover an end of the conductive region which extends from said hole.

The above-described device, may further include a second substrate which is bonded to a portion of the first side of the first substrate.

In the above-described device, the insulating dielectric region may extend from the hole at the second side of the first substrate and cover a portion of the second side of the first substrate; a second circuit may be provided at an end of the through-hole interconnection at the second side of the first substrate; and a bump may provided on the second circuit.

In the above-described device, the second circuit may be a multilayered circuit and the layers of the circuit may be interposed by a second insulating layer.

In the above-described device, the multilayered circuit may comprise a two-layered structure and the two layers may be connected by a second through-hole interconnection formed through the second insulating layer.

A second aspect of the invention is a method for manufacturing a device including the steps of: providing a first substrate including a first side and a second side, a functional element being provided on the first side of the first substrate, and a pad electrically connected to the functional element; and forming a hole from the second side of the first substrate until the pad is exposed; forming a conductive region that is made of a second conductive material on at least a portion of an inner surface of the hole,; and filling the first conductive material in the hole to define a through-hole interconnection, wherein the second conductive material is different from the first conductive material.

In the above-described method, after the step of forming the hole, the step of forming a conductive region that is made of the second conductive material that is different from the first conductive material on at least a portion of an inner surface of the hole is carried out before the step of filling the first conductive material in the hole to define a through-hole interconnection. Therefore, it is possible to provide a conductive region made of the second conductive material that is different from the first conductive material of which the through-hole interconnection is to be made between at least a portion of the inner surface of the hole and the through-hole interconnection. By controlling the method and conditions for forming this conductive region, the conductive region can be provided at a desired location, such as at least one of the inner side wall and the bottom of the hole to a desired thickness.

The above-described method may further include the step of patterning the conductive region made of the second conductive material using a dry film resist.

The above-described method may further include providing a circuit connecting the functional element and the pad.

In the device according to the first aspect of the invention, since the conductive region made of the second conductive material can prevent formation of a gap, diffusion of a material, or oxidation that occur between the inner surface of the hole and the through-hole interconnection that is made of the first conductive material, the stability of the electrical connection between the pad and the through-hole interconnection is improved. Thus, the invention can provide a device having long-term stability.

Furthermore, since the method for manufacturing a device according to the second aspect of the invention includes the step of providing a conductive region that is made of a second conductive material on at least a portion of an inner surface of the hole, the method can provide a device that can prevent formation of a gap, diffusion of a material, or oxidation that occur between the inner surface of the hole and the through-hole interconnection.

### BRIEF DESCRIPTION OF THE DRAWINGS

The above and other objects, features and advantages of the invention will become more apparent by describing in detail exemplary embodiments thereof with reference to the attached drawings in which:

FIG. 1 is a schematic cross-sectional view illustrating an exemplary embodiment of the device according to the invention;

FIG. 2 is a schematic cross-sectional view illustrating another exemplary embodiment of the device according to the invention;

FIG. 3 is a schematic cross-sectional view illustrating another exemplary embodiment of the device according to the invention;

FIG. 4 is a partial schematic cross-sectional view illustrating another exemplary embodiment of the device according to the invention;

FIG. 5 is a partial schematic cross-sectional view illustrating another exemplary embodiment of the device according to the invention;

FIG. 6 is a partial schematic cross-sectional view illustrating another exemplary embodiment of the device according to the invention;

FIG. 7 is a schematic cross-sectional view illustrating another exemplary embodiment of the device according to the invention;

FIG. 8 is a schematic cross-sectional view illustrating another exemplary embodiment of the device according to the invention;

FIG. 9A to 9F are schematic cross-sectional views illustrating steps in a method for manufacturing a device according to an exemplary embodiment of the invention;

FIG. 10 is a graph showing results of Auger electron spectroscopy;

FIGS. 11A to 11E are cross-sectional views illustrating manufacturing processes in a first related art manufacturing method; and

FIGS. 12A to 12C are cross-sectional views illustrating manufacturing processes in a second related art manufacturing method.

### DETAILED DESCRIPTION OF THE INVENTION

Exemplary embodiments of the invention will now be described below by reference to the attached Figures. The described exemplary embodiments are intended to assist the understanding of the invention, and are not intended to limit the scope of the invention in any way.

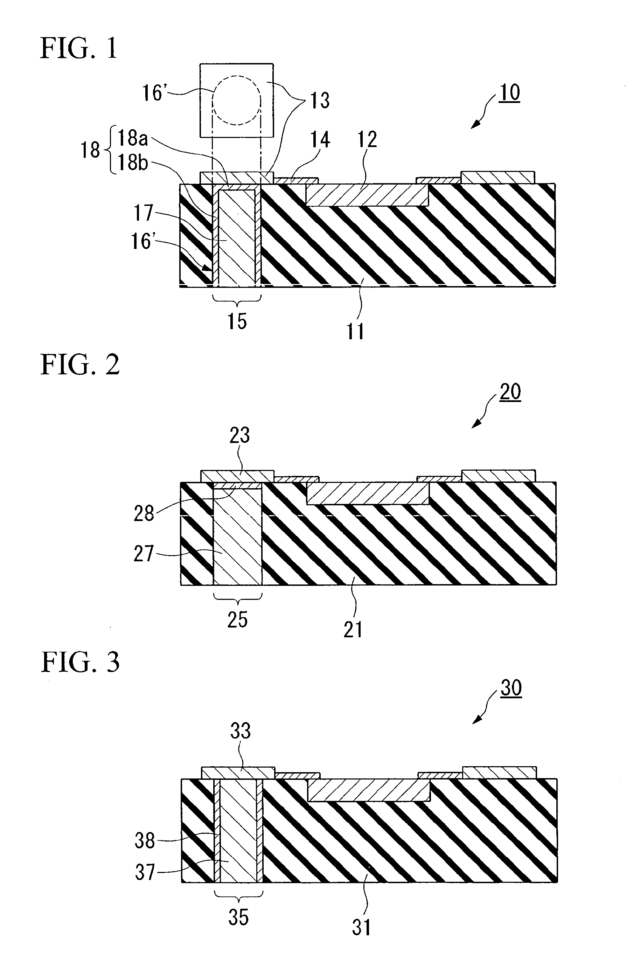

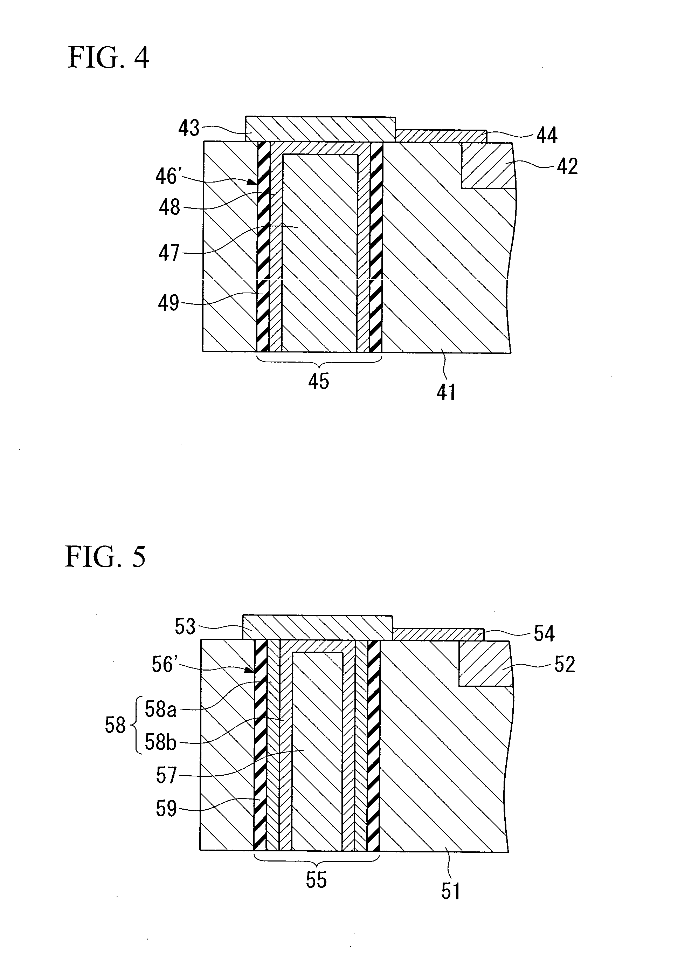

More specifically, FIGS. 1 to 3 illustrate exemplary embodiments in which an insulating substrate is used, and FIGS. 4 to 6 illustrate exemplary embodiments in which a conductive substrate is used. Each figure schematically shows the structure of the device according to an exemplary embodiment of the invention, and some are accompanied by a plan view in order to provide a clearer understanding.

FIG. 1 is a schematic cross-sectional view illustrating an exemplary embodiment of the device according to the present invention, and a small hole (hole) is provided and the entire inner wall of the hole is completely covered by a conductive region made of a second conductive material. As used herein, the term "the entire inner wall of a hole" includes the bottom of the hole (i.e., the back side of a pad) and the inner side wall of the hole.

A device 10 shown in FIG. 1 includes a first substrate 11 made of an insulating material, for example, glass, ceramic, or the like, a functional element 12, for example, a light-emitting device, pads 13 that are provided on a first side (the upper side in the figure) of the first substrate 11, first circuit (wiring) 14 that electrically connects between the functional element 12 and the pads 13, a through-hole interconnection 15 that is electrically connected to a pad 13, and a conductive region 18. The through-hole interconnection 15 is formed by filling a first conductive material 17 in at least a portion of the inner surface 16' of the hole from the first side toward a second side (lower side in the figure). The conductive region 18 is made of a second conductive material that is different from the first conductive material 17. Here, the inner surface of the hole includes the bottom of the hole that defines the back side (the side that had been in contact with the first substrate 11 before the hole was formed) of the pad 13 and the inner side wall of the hole. Reference numeral 18a denotes a part of the conductive region that is provided on the bottom of the hole. Reference numeral 18b denotes the rest of the conductive region that is provided at the inner wall of the hole.

As materials of the pad 13 and the first circuit 14, materials that exhibit an excellent conductivity are preferably used, such as aluminum (Al), copper (Cu), an aluminum-silicon (Al-Si) alloy, or an aluminum-silicon-copper (Al-Si-Cu) alloy. These materials are, however, oxidized easily.

As the first conductive material 17 of the through-hole interconnection 15, solders, such as a tin (Sn) based, lead (Pb) based, gold (Au) based, Indium (In) based, and aluminum (Al) based solders, or the like, are preferably used, in addition to metals, such as tin (Sn), a gold-tin (Au-Sn) based alloy, or the like.

As the second conductive material of the conductive region 18, materials that exhibit conductivity and an excellent wettability with respect to the first conductive material 17 of the through-hole interconnection 15, are resistant to oxidation, and are capable of preventing diffusion of an element included in the first conductive material 17 may be preferably used. Examples of such materials include gold (Au), titanium (Ti), titanium-tungsten (TiW) when a single layer is used, and Au (upper layer) / Cu (lower layer) when a stacked layer is used.

The conductive region 18 is disposed to at least a portion of the inner surface 16' of the hole, so that it exhibits its effectiveness.

FIG. 2 is a schematic cross-sectional view illustrating another exemplary embodiment of a device 20 with substrate 21 according to the present invention. In this figure, a portion 28 of the conductive region (hereinafter, referred to as "the conductive region 28") is provided only on the bottom of the hole that defines the back side of the pad 23, which corresponds to 18a in the embodiment shown in FIG. 1. By providing such a conductive region on the back side of the pad 23, the conductive region 28 helps maintain an excellent conductivity between the pad 23 and the through-hole interconnection 25 for a long time because oxidation of the pad 23 can be prevented.

In the structure shown in FIG. 2, materials that are capable of improving the adhesion between the first conductive material 27 and the pad 23 are preferably used as the conductive region 28. A specific example is gold-tin (Au-Sn) based alloy as the first conductive material 27 and nickel (Ni) as the conductive region 28 when the pad 23 has a double-layered structure made of Cr and Cu. Preferably, Ni is formed using an plating or sputtering method.

FIG. 3 is a schematic cross-sectional view illustrating another exemplary embodiment of a device 30 according to the present invention. In this figure, a portion 38 of the conductive region (hereinafter, referred to as "the conductive region 38") is provided only on the side wall of the hole, which corresponds to 18b in the embodiment shown in FIG. 1. By providing the hole in the first substrate 31 with such a conductive region, the displacement of the through-hole interconnection 35 in the hole due to a weakened adhesion between the through-hole interconnection 35 and the first substrate 31, and thus slipping off of the through-hole interconnection 35 from the hole can be prevented. As a result, the through-hole interconnection 35 can maintain an excellent conductivity to pad 33 for a long time.

In the structure shown in FIG. 3, the conductive region 38 preferably has a property of preventing the diffusion of an element contained in the first conductive material 37 into the first substrate 31. As a specific example of combination of materials, nickel (Ni) or titanium nitride (TiN) is used for the conductive region 38 when the first conductive material 37 is made of gold-tin (Au-Sn) based alloy and the first substrate 31 is made of silicon. Preferably, Ni is formed using an plating or sputtering method, and TiN is formed by the sputtering or the chemical vapor deposition (CVD) method.

The conductive region 18 may be disposed on the entire surface of the inner surface 16' of the hole, as shown in FIG. 1. Providing both the conductive region 18a and the conductive region 18b is preferable since a long-term reliability of the conductivity of the through-hole interconnection 17 can be assured, in addition to a long-term reliability of the conductivity between the pad 13 and the through-hole interconnection 17.

Furthermore, in the structure shown in FIG. 1, materials that are capable of improving the adhesion between the inner surface of the hole 16' and the pad 13 are preferably used for the conductive region 18. As a specific example of combination of materials for improving adhesion, gold (Au) is used for the conductive region 18 when the first conductive material 17 is made of a gold-tin (Au-Sn) based alloy. In this case, Au is preferably formed using an plating or sputtering method.

In the structure shown in FIG. 1, the conductive region 18 preferably has a property of preventing the diffusion of an element contained in the first conductive material 17 into the first substrate 11. As a specific example of combination of materials for preventing diffusion of a material, nickel (Ni) is used for the conductive region 18 when the first conductive material 17 is made of a gold-tin (Au-Sn) based alloy. In this case, Ni is preferably formed using an plating or sputtering method.

In FIG. 1, a plan view of the pad 13 is shown in order to clarify the positional relationship between the pad 13 and the through-hole interconnection 15. The region of contact between the through-hole interconnection 15 and the pad 13 (i.e., a circular region defined by the circumference of the hole 16') is preferably positioned within the region of contact between the pad 13 and the first substrate 11 having a rectangular circumference. In this configuration, when the hole is formed from the second side (lower side in the figure) of the first substrate 11, it is ensured that the entire region of contact between the through-hole interconnection 15 and the pad 13 is located within the region of contact between the pad 13 and the first substrate 11. Thus, the contact between the pad 13 and the first substrate 11 is established.

In this structure, since there is no gap between the first substrate 11 and the pad 13, the first conductive material 17 is prevented from flowing to the first side (the upper side in the figure) of the first substrate 11 when the first conductive material 17 is filled in the hole to form the through-hole interconnection 15. Thus, adverse effects on the circuit 14 and the device 12 that have been provided on the first substrate 11 can be prevented. Accordingly, it is possible to form a highly reliable electrical connection.

FIGS. 4 to 6 are partial schematic cross-sectional views illustrating other embodiments of the device according to the present invention, in which a conductive material, such as silicon or gallium arsenide, are used for the first substrate.

FIG. 4 is a partial schematic cross-sectional view illustrating another exemplary embodiment of the device according to the present invention. In this figure, a dielectric region 49 made of an insulating material is provided on the inner side wall 46' of the hole, and the entire inner wall (i.e., dielectric region 49 and the back side of the pad 43) is covered by the conductive region 48 made of a second conductive material. As the insulating material for the dielectric region 49, silicon dioxide (SiO2), silicon nitride (SiN), or silicon oxide nitride (SiNOx) may be used, for example.

That is, when the first substrate 41 is made of a conductive material, it is possible to define the structure mentioned above by providing the dielectric region 49 made of an insulating material on the inner side wall 46' of the hole in the first substrate 41. It is possible to maintain an excellent electrical connection between the pad 43 and the conductive material 46 in through-hole interconnection 45 for a long time in the device shown in FIG. 4 by covering the dielectric region 49 and the back side of the pad 43 with the conductive region 48 made of a second conductive material, as shown in FIG. 4. The pad 43 being electrically connected to a functional element 42 through a first circuit (wiring) 44.

FIG. 5 is a partial schematic cross-sectional view illustrating another exemplary embodiment of the device according to the present invention. Similar to the exemplary embodiment of FIG. 4, the device includes a first substrate 51, a functional element 52, a first circuit (wiring) 54 and a through-hole interconnection 55. In this figure, after a dielectric region 59 made of an insulating material is provided covering only the side wall 56' of the hole, a conductive region 58a made of a third conductive material is provided only on the dielectric region 59. Then, the conductive region 58a and the back side of a pad 53 is covered by a conductive region 58b made of a second conductive material.

As shown in FIG. 5, the conductive region 58 has a two-layered structure, and each layer has a different function. For example, for the third conductive material of the outer conductive region 58a that contacts with the dielectric region 59, a material that exhibits an excellent adhesion to the dielectric region 59 may be used. In contrast, for the second conductive material that contacts with the first conductive material 57 of which the through-hole interconnection is made, a material that has an excellent wettability with respect to the first conductive material 57 is preferably used. For example, when the dielectric region 59 is made of silicon dioxide (SiO2) and the first conductive region 57 (i.e., the through-hole interconnection) is made of gold-tin (Au-Sn) alloy, chromium may be used for the third conductive material for the conductive region 58a and gold may be used for the second conductive material for the conductive region 58b.

In the example shown in FIG. 5, the conductive region 58a only covers the dielectric region 59. Alternatively, after providing the conductive region 58a so as to cover both the dielectric region 59 and the back side of the pad 53, the conductive region 58b may be provided to cover the entire conductive region 58a.

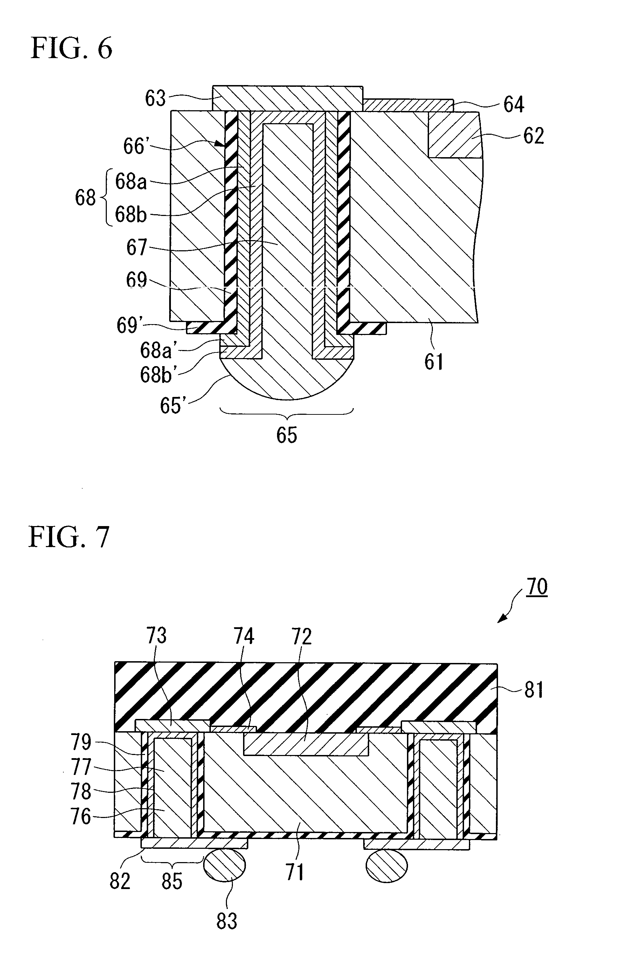

FIG. 6 is a partial schematic cross-sectional view illustrating another exemplary embodiment of the device according to the present invention. The device of FIG. 6 is different from the device of FIG. 5 in that both the dielectric region and the conductive regions extend from the opening of the hole toward the second side of the first substrate.

The dielectric portion 69, the conductive region 68, which is formed of two layers of conductive regions, 68a and 68b, are similarly provided in the inner side wall 66' of the hole to the device of FIG. 5, and this embodiment is characterized by the relative length of ends 69', 68a', and 68b' that extend from the opening of the hole toward the second side of the first substrate. More specifically, the end 69' of the dielectric portion 69 may be longest, and the end 68a' of the conductive region 68a and the end 68b' of the conductive region 68b may be shorter than the end 69'. According to this structure, since it is ensured that the end 69' of the dielectric portion 69 is provided between the first substrate 61 that is made of a conductive material and the end 68a' of the conductive region 68a or the end 68b' of the conductive region 68b, it is possible to prevent a short-circuit between the first substrate 61 and the conductive region 68a or the conductive region 68b.

In the hole having the above-described structure, upon forming the through-hole interconnection 65 by filling the first conductive material 67 in the hole, the end of the through-hole interconnection 65 protrudes from the opening of hole toward the outside (i.e., lower side in FIG. 6), defining a hemispherical end. The hemispherical end 65' of the through-hole interconnection 65 is so shaped that the hemispherical end 65' completely covers the end 68b' of the conductive region 68b.

Such a protruding hemispherical end 65' of the through-hole interconnection 65 is preferable since it can be used as a terminal with which a functional element 62 disposed on the first side of the substrate can define an electrical contact with an external element. The functional element being connected to a pad 63, through a first circuit (wiring) 64.

FIG. 7 is a schematic cross-sectional view illustrating another exemplary embodiment of a device 70 according to the present invention. The device of FIG. 7 has the following characteristics, provided that a conductive material, such as silicon or gallium arsenide, is used as the first substrate 71, and an insulating material, such as glass or ceramics, is used as the second substrate 81:
(a) A second substrate 81 is bonded to at least a portion of a first side (the upper side in the figure) of a first substrate 71.
(b) A second substrate 81 is positioned such that the second substrate 81 covers at least a portion of pads 73.
(c) A dielectric region 79 extending from holes 76 cover the entire surface of a second side (lower side in the figure) of the first substrate 71 and second circuit (wiring) 82 that is electrically connected to a through-hole interconnection and a conductive region 78 is provided. The through-hole interconnection 75 includes a first conductive material 77. In addition, bumps 83 are provided on the second circuit 82.

By providing the second substrate 81 described in Item (a) on the first substrate 71 on which a functional element 72, first circuit 74, pads 73, and through-hole interconnections are provided, the device can be used as a package after the formation of through-hole interconnections.

In particular, as described in Item (b), by positioning the second substrate 81 such that the second substrate 81 covers at least a portion of pads 73, it is possible to prevent the deformation of the pads or the deterioration of the strength of the pads due to stress after the formation of holes 76.

Furthermore, since the pads are very thin (for example, about 1 µm), the pads may be damaged or broken during the process for forming the hole from the second side of the first substrate in the related art technique. To prevent damage to or breakage of the pads, as shown in FIG. 7, the second substrate 81 is provided so that it contacts the first side of the first substrate 71 sandwiching the pads 73. In this configuration, if the back side of the pads 73 (the side in contact with the first substrate) are subjected to some kind of force during the formation of the holes, the second substrate 81 contacting the front side (the side in contact with the second substrate) of the pads 73 supports the pads 73. As a result, the pads 73 supported by the second substrate 81 are less affected by the hole formation process, and the damage to or breakage of the pads 73 can be prevented.

Furthermore, by providing the second circuit 82 and the bumps 83 as described in Item (c), it is possible to realize a chip-level packaging. Thus, the reduction in the size of the device can be attained. In particular, by changing the position of the second circuit 82, the spacing between a through-hole interconnection and a bump 83 can be changed to any value. For example, even when the pitch between through-holes is narrow, the pitch between bumps 83 can be increased by appropriately arranging the second circuit 82. Thus, the device and an external element can be bonded easily. In addition, since the second circuit 82 allows bumps 83 to be provided in regions other than the region above the through-hole interconnections, the through-hole interconnection may be less affected by heat or mechanical forces during the process for forming the bumps 83, or bonding process to the bumps 83. Thus, the reliability of the electrical connection between a through-hole interconnection and a bump 83 may be enhanced.

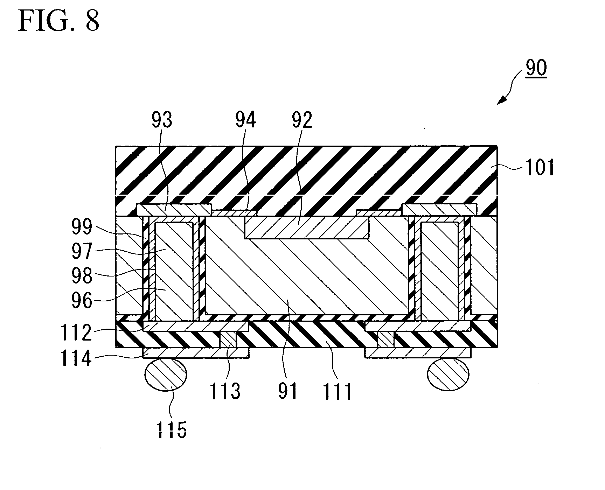

FIG. 8 is a schematic cross-sectional view illustrating another exemplary embodiment of the device according to the present invention. The device on FIG. 8 has the following characteristics, and other than those, the device of FIG. 8 has a structure which is similar to that of the above-described device of FIG. 7:
(d) Multi-layered circuit having at least two layers is provided on a second side (lower side in the figure) of a first substrate 91, and the layers of the circuit are interposed by an insulating layer 111 made of a resin, for example. In the example shown in FIG. 8, the circuit has a two-layered structure having second circuit 112 and third circuit 114.
(e) The second circuit 112 and the third circuit 114 are electrically connected via a through-hole interconnection 113 that is made of a conductive material.
(f) A bump 115 is provided on third circuit 114 that is located the surface of the insulating layer 111.

Similar to the device of FIG. 7, by providing a second substrate 101 on the first substrate 91 on which a functional element 92, circuit 94, pads 93, and through-hole interconnections are provided, the device 90 of FIG. 8 can be used as a package after the formation of through-hole interconnections. Also similar to Fig. 7, the device of FIG. 8 includes a hole 96, a first conductive material 97, a conductive region 98 and a dielectric region 99.

Furthermore, by providing the bumps 115 so as to electrically connect to the second circuit 112 as described in Item (f), it is possible to realize a chip-level packaging. Thus, the reduction in the size of the device can be attained. In particular, since the device of FIG. 8 has a multilayered structure having at least two layers on the second side of the first substrate 91, the flexibility of the selection of the positions of the bumps 115 that function as electrical contacts with an external element can be further enhanced. It may be possible to provide the bumps 115 above the through-hole interconnection, as shown in FIG. 8, for example.

A method for manufacturing a device according to the present invention includes: Step A of providing a first substrate including a first side and a second side, in which a functional element is provided on the first side of the first substrate, first circuit connects to the functional element, and a pad electrically connects the functional element via the first circuit; and Step B of providing the hole from the second side of the first substrate until the pad is exposed; Step C providing a conductive region that is made of a second conductive material on at least a portion of an inner surface of the hole, in which the second conductive material being different from a first conductive material; Step D of filling the first conductive material in the hole.

In this configuration, it is possible to effectively fabricate a device having the above-described structure (i.e., a device includes a conductive region made of a second conductive material that is different from the first conductive material of the through-hole interconnection is provided, as shown in FIG. 1) on at least a portion of the inner surface of the hole. Furthermore, since the front side of the pads can be covered by a conductive region (metal thin film) immediately after holes are formed and the pads are exposed, the surface side of pads can be protected by the conductive region made of a stable second conductive material even if the pads are made of a metal that is oxidized easily, for example, aluminum. Thus, the pads can establish a highly reliable electrical connection with the filled first conductive material via the conductive region.

In the above-described Step B, the deep-reactive ion etching method (hereinafter, referred to as "DRIE method") may be used to form holes. Since the DRIE method enables formation of holes with high precision, holes can be formed within the circumference of the pads.

Hereinafter, the procedures for forming holes in Step B will be explained using an example in which a first substrate is a silicon wafer. A typical silicon wafer includes a substrate (Si) and an oxide layer (SiO₂) formed thereon. Pads made of aluminum (Al) are disposed on the oxide layer (SiO₂) that defines a first side of the first substrate, and holes are formed from a second side of the first substrate in the following two Steps (i) and (ii):
(i) Portions of the second side of the substrate (Si) to which holes are to be formed are exposed to a first plasma generated using a first gas containing SF6 that is capable of etching the substrate (Si).
   Holes having a certain opening size are started to be formed in the second side of the substrate (Si), and the depth thereof is gradually increased. Since the etch rate of the oxide layer (SiO₂) by the first plasma is very small compared to the etch rate of silicon, the etching reaction stops when the oxide layer (SiO₂) is exposed. Thus, the formation of the holes using the first gas is completed. In other words, the oxide layer (SiO₂) also functions as an etch stopper.
(ii) Then, a second plasma generated using a second gas containing CF₄ is irradiated to the hole. CF₄ is capable of etching the oxide layer (SiO₂). Since the second plasma does not etch the substrate (Si), the oxide layer (SiO₂) exposed at the bottom of holes is etched. The depth of the holes increases as SiO₂ is removed. Since the second plasma does not etch pads (Al), the etching reaction stops when the pads (Al) are exposed. Thus, the formation of the holes using the second gas is completed. In other words, the pads (Al) also function as an etch stopper.

In the two etching steps described above, holes that are opened to the second side of the first substrate, and have a bottom that define the back side of a pad are formed.

In the above-described Step C, a conductive region is formed so that it extends from an opening of a hole to the second side of the first substrate. By forming the conductive region so that it extends from the inner wall of a hole to the proximity of the opening of the hole, circuit formed on the back side of the first substrate can establish a more reliable electrical connection and the adhesion can be further improved.

In the above-described Step C, the conductive region is formed by stacking two or more layers made of different materials. The first layer of the multilayered structure may be made of a material that has an excellent adhesion to the first substrate and a second layer may be formed using a continuous film deposition process, for example. As a result, the efficiency of the production process can be enhanced.

In the above-described Step D, the Molten Metal Suction Method is used to fill the first conductive material. By forming a conductive region on the inner wall of a hole, it is possible to significantly enhance the adhesion between a molten metal (a first conductive material for the through-hole interconnection) that is filled using the Molten Metal Suction Method and the first substrate compared to related art techniques.

The conductive region made of the second conductive material that has been formed in the above-described Step C may be patterned using a dry film resist. In a wet resist patterning process, a liquid resist is typically used, and since the resist may flow into the holes, the removal of which in a later step is difficult. The resist remaining within the holes may adversely affect electric characteristics of through-hole interconnections. In contrast, when a dry film resist is used, the resist covers the opening of the holes. Accordingly, since the patterning using the dry film resist is free from the above-described remaining problem in the holes, through-hole interconnections exhibiting excellent electric characteristics can be formed.

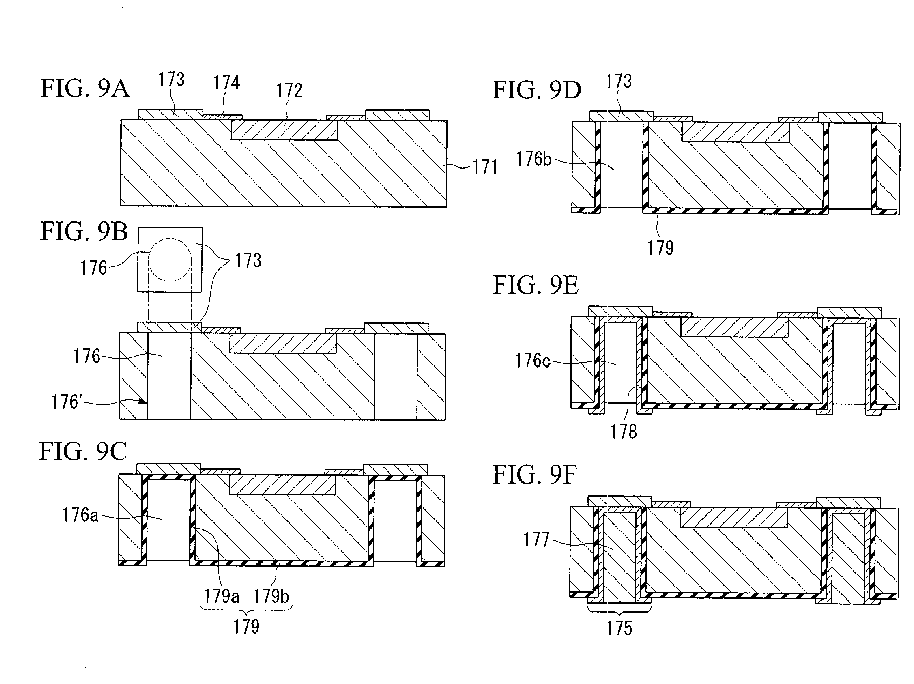

Hereinafter, a method for manufacturing a device according to an exemplary embodiment of the present invention will be explained in detail with reference to FIG. 9A to 9F. FIG. 9A to 9F are schematic cross-sectional views illustrating steps in the method for manufacturing a device according to an exemplary embodiment the present invention, and some are accompanied by a plan view in order to provide a clear understanding.

In FIG. 9A, a solid-state image sensing device is shown. The device is fabricated using related art manufacturing processes and includes a substrate 171 that is made of silicon, a functional element 172 including a group of photodiodes and a group of microlenses, pads 173 for providing a connection with an external element, and circuits 174 that electrically connecting between the pads 173 and the functional element 172. In this example, the silicon substrate 171 has a thickness of 200 µm, and the pads 173 and circuits 174 are made of aluminum (Al). The pads 174 are squares of 100 µm × 100 µm.

First, as shown in FIG. 9B, holes 176, with inner surfaces 176', penetrating through the substrate 171 are formed from the side (lower side in the figure) opposing to the side on which the functional element 172 is formed at the position opposing to pads 173 (the upper side in the figure) until the back side of the pad is exposed. In this step, the entire circumference of the inner wall of a hole 176 right below a pad 173 is within the circumference of the pad 173. By this, the contacting region between a through-hole interconnection 175 and a pad 173 is defined when a conductive material is filled in the hole 176 to form the through-hole interconnection 175 in a later step.

In this example, a hole 176 having a diameter of 80 µm is defined by removing silicon of the substrate 171, followed by removal of an insulating layer made of SiO₂ or the like (not shown) that is typically provided under the pad using a dry etching. In this example, the deep-reactive ion etching (DRIE) method is used for etching silicon. In the DRIE method, a silicon substrate is etched at a high aspect ratio by alternately conducting etching with a high-density plasma using sulfur hexafluoride (SF₆) as an etching gas and formation of a passivation film to the side walls (Bosch process). The RIE (reactive ion etching) with carbon tetrafluoride (CF₄) is used for etching SiO₂.

Then, as shown in FIG. 9C, an insulating layer 179 is formed on the inner wall of the holes 176 and on a second side (lower side in the figure) of the substrate 171 made of silicon. In other words, the insulating layer 179 includes a portion 179a that covers the inner wall of the hole 176 and a portion 179b that covers the second side of the substrate 171. The hole after the insulating layer 179 will be denoted by reference symbol 176a. In this example, the insulating layer 179 made of silicon oxide (SiO₂) is formed with the plasma CVD method using tetraethoxy silane (TEOS) as a source.

Then, as shown in FIG. 9D, a portion of the insulating layer 179 made of SiO₂ that is located at the bottom of the hole 176a is removed using an etching method. The portion of the insulating layer 179 made of SiO₂ that is located at the bottom of the hole 176a is the region that contacts the back side of the pad 173. In order to remove the insulating layer 179 made of SiO2 located at the bottom of the hole 176a, an anisotropic etching process is carried out after protecting the SiO2 layer on the second side of the substrate 71 using a resist or the like. In this example, the RIE (reactive ion etching) with carbon tetrafluoride (CF₄) is used for etching SiO₂. The hole in which the back side of the pad 173 is exposed after etching the SiO₂ laye at the bottom of the hole will be denoted by reference symbol 176b.

Next, as shown in FIG. 9E, a conductive thin film 178 is formed on the inner wall and around the opening of the hole 176b. In this example, the conductive thin film 178 having a two-layered structure is formed by depositing chromium (Cr) as a first layer and gold (Au) as a second layer using the sputtering method. In this process, the inner wall of the hole 176b, i.e., the insulating layer 179 made of SiO₂ defining the inner side wall of the hole and the back side of the pad 173 defining the bottom of the hole is covered by the conductive thin film 178 having a two-layered structure. The resulting hole will be denoted by reference symbol 176c.

Then, as shown in FIG. 9F, a conductive material 177 is filled in the holes 176c to form through-hole interconnections 175 that electrically connect to the pads 173. In this example, gold-tin (Au-Sn) alloy containing 80% by weight of gold and 20% by weight of tin is used as the conductive material 177, and the through-hole interconnections 175 are formed using the Molten Metal Suction Method.

It should be noted that although the pad 173 is a square of 100 µm × 100 µm in this example, the pad 173 may have a shape other than a square, including a circle, an oval, a triangle, or a rectangle. The pad 173 may have any size provided that the pad functions as an electric circuit. Furthermore, although the pad 173 and the circuit 174 are made of aluminum in this example, the present invention is not limited to aluminum and any circuit material may be used, including copper (Cu), aluminum-silicon (Al-Si), or aluminum-silicon-copper (Al-Si-Cu).

Furthermore, the circumference of the holes 176 is a circle having a diameter of 80 µm in this example. However, the size of the hole 176 is not limited to the diameter, and the holes 176 may have any size provided that the contact region with the pad 173 is within the circumference of the pad 173. In addition, the circumference of the hole 176 may be a shape other than a circle, including an oval, a square, a triangle, or a rectangle. Furthermore, the method for forming the hole 176 is not limited to the DRIE method, and the wet etching using a potassium hydroxide (KOH) aqueous solution may be used.

In this example, the insulating layer 179 made of SiO2 is formed on both the inner wall of the hole 176 and the second side of the substrate 171 with the plasma CVD method using TEOS as a source. The present invention, however, is not limited to this example, and silane (SiH₄) may be used as a source. Furthermore, the insulating layer 179 may be formed by coating with an insulating resin, rather than depositing SiO₂ using the plasma CVD method.

Furthermore, although the conductive thin film 178 has the two-layered structure made of chromium and gold in this example, the present invention is not limited to this layer structure and different materials may be used provided the materials have a property of improving the adhesion with the filled conductive material and the inner wall of a hole. The number of the layers is not limited to two, and a multilayered structure including three or more layers is possible. The method for forming the conductive thin film 178 is not limited to the sputtering method, and other methods, such as the CVD or evaporation may be used.

In the example described above, gold-tin (Au-Sn) alloy containing 80% by weight of gold and 20% by weight of tin is used as the conductive material 177, but the present invention is not limited to this example. For example, gold-tin alloys with different compositions; tin-lead (Sn-Pb) alloys; metals such as tin (Sn) or indium (In); or solders such as tin (Sn) based, lead (Pb) based, gold (Au) based, indium (In) based, or aluminum (Al) based solders may be used.

### Examples

The following provides a description of specific examples. However, although the invention will be explained below in more detail by reference to the following Examples, the invention should not be construed as being limited to the following Examples only. It is to be expressly understood, that the Examples are for purpose of illustration only and are not intended as a definition of the limits of the invention.

### Example 1

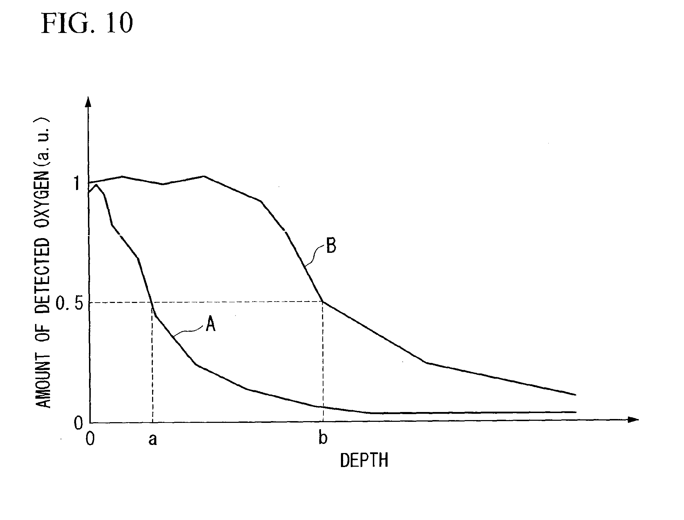

In this example, as shown in FIG. 2, a stacked layer made of Au (thickness: 300 nm) / Cr (thickness: 50 nm) was provided as a conductive region 28 only on the bottom of holes that defined the back sides of pads 23. The Au layer was the upper layer contacting the through-hole interconnections 27, and the Cr layer was the lower layer contacting the back side of the pads 23. Then, this sample was designated as Sample A without providing through-hole interconnections 27. After the Sample A was allowed to stand in the air for 240 hours, the oxygen content of the stacked layer that defined the conductive region 28 was examined from the surface of the gold layer using Auger Electron Spectroscopy. FIG. 10 is a graph showing results of Auger Electron Spectroscopy. In FIG. 10, Curve A represents the result of Sample A. In Sample A, the measurement was carried out from the side of the conductive region 28, and horizontal axis represents the depth. The origin (value 0) of the horizontal axis corresponds to the depth at which much aluminum began to be detected. The vertical axis represents the amount of oxygen detected, and the value of 1 represents the amount at the depth in which much aluminum began to be detected.

### Comparative Example 1

In this comparative example, Sample B that had the same structure as the embodiment shown in FIG. 2 was prepared except that the conductive region 28 was omitted, and the evaluation described in Example 1 was carried out on Example B. In other words, Sample B did not have the conductive region 28, and the inner surface of the holes remained open without forming through-hole interconnections 27. In FIG. 10, Curve B represents the result of Sample B. In Sample B, the horizontal axis represents the depth calculated from the etching time of aluminum, and the origin (value 0) of the horizontal axis corresponds to the surface (aluminum) of the back side of the pad. The vertical axis represents the amount of oxygen detected, and the value of 1 corresponds to the oxygen amount observed at the surface of aluminum layer. FIG. 10 indicates that the depths at which the oxygen content at the surface was half are the depth "a" for Sample A and the depth "b" for Sample B. In addition, the depth "b" was more than three times deeper than the depth "a", meaning that Sample B was oxidized to a depth three times greater than Sample A.

In other words, an oxide layer was formed on the back side of the pads in Sample B in which the surface (aluminum) of the back side of the pads remained open, which is undesirable since the oxide layer decreases the conductivity of the through-hole interconnections that are to be formed later.

In contrast, the extent of oxidation of aluminum in Sample A in which the conductive region 28 made of Au/Cr was provided on the back side of the pads 23 was one third that in Sample B, which is preferable since a good electrical contact is established between the pads 23 and the through-hole interconnections that are to be formed later. In other words, gold in the conductive region 28 functions to prevent the oxidation of aluminum.

### Example 2

In this example, as shown in FIG. 3, a stacked layer made of Au (thickness: 300 nm) / Cr (thickness: 50 nm) was provided as the conductive region 38 only on the side wall of holes defined in the first substrate 31. The Au layer was the upper layer contacting the through-hole interconnection 37, and the Cr layer was the lower layer contacting the inner wall of the hole. Then, the samples provided with the through-hole interconnections 37 were designated as Samples C. Then, a reliability test including the following three test items was carried out on Examples C (number of samples: 100). Before and after the reliability test, the resistance between a through-hole interconnection 37 and a pad 33 was measured, and samples exhibiting a rate of increase of 50% or lower were judged as passed samples. The results of the reliability test of Samples C were listed in Table 1.

In the reliability test, the samples were held at high temperatures (first test), or were held at high temperatures and at high humidity (second test), or were held at a heat cycle (third test). The three tests were carried in the above-described order.

In the high temperature test (first test), the samples were held at a temperature of 90°C in the air for 240 hours in total. In the high temperature and high humidity test (second test), the samples were held at a temperature 70°C and a humidity of 90%HR in the air for 240 hours in total. In the heat cycle test (third test), samples were held at two different temperatures (-40°C and 125°C) alternately in the air for 240 hours in total.

One heat cycle consists of four steps: Steps 1 to 4, and each cycle lasts for 2 hours. In Step 1, a temperature of -40°C was maintained for 30 minutes. In step 2, the temperature was raised from -40°C to 125°C in 30 minutes. In step 3, a temperature of 125°C was maintained for 30 minutes. In Step 4, the temperature was reduced from 125°C to -40°C in 30 minutes.

### Example 3

In this example, as shown in FIG. 1, a stacked layer made of Au (thickness: 300 nm) / Cr (thickness: 50 nm) was provided as a conductive region 28 on the entire surface of holes. The Au layer was the upper layer contacting the through-hole interconnections 17, and the Cr layer was the lower layer contacting the back sides of pads 33 and the side wall of the holes in the substrate 11. Then, the samples provided with the through-hole interconnections 17 were designated as Samples D. Then, the reliability test described in

Example 2 was performed on Samples D (number of samples: 100). Before and after the reliability test, the resistance between a through-hole interconnection 17 and a pad 13 was measured, and samples exhibiting a rate of increase of 50% or lower were judged as passed samples. The results of the reliability test of Samples D were listed in Table 1.

### Comparative Example 2

In this comparative example, Samples E (number of samples: 100) that had the same structure in the embodiment shown in FIG. 3 were prepared except that the conductive region 38 was omitted, and the evaluation described in Example 2 was carried out on Examples E. In other words, Samples E did not have the conductive region 38, and the inner surface of the holes was exposed while providing the through-hole interconnection 37. The results of the reliability test of Samples E were listed in Table 1.

**Table 1**

| Symbol of Samples | C | D | E |
|---|---|---|---|
| Number of Passed samples after Reliability Test | 92 | 99 | 56 |

From Table 1, the following observations are made:
(1) Among samples C in which a stacked layer made of Au/Cr was provided as the conductive region 38 on the inner wall of the first substrate 31 defining the inner wall of holes, 92 samples were determined as passed samples, which corresponded to a passed sample rate of 90%.
(2) Among Samples D in which a stacked layer made of Au/Cr was provided as the conductive region 18 on the entire inner surface of the hole, 99 samples were determined as passed samples, which corresponded to a passed sample rate of nearly 100%. Thus, the number of defective samples will be small.
(3) In contrast, in Samples E without the conductive region 38, only 56 were determined as passed samples, which corresponded to a passed sample rate of less than 60%.

These evaluation results indicate that provision of the conductive region 38 only to the side wall of a hole can sufficient to maintain a good conductivity of a through-hole interconnection. In addition, provision of the conductive region 18 to the entire inner region of the hole may improve the passed sample rate to nearly 100%. Accordingly, the embodiment in which the conductive region 18 is provided to the entire inner region of the hole (shown in FIG. 1) is the most preferable.

According to the present invention, a device having a highly reliable electrical connection can be provided. Thus, the present invention can improve the impact resistance or a long-term reliability of apparatuses that are often subjected to external impacts or the like, for example, mobile telephone terminals or camcorders.

While preferred embodiments of the invention have been described and illustrated above, it should be understood that these are examples of the invention and are not to be considered as limiting. Additions, omissions, substitutions, and other modifications can be made without departing from the spirit or scope of the present invention. Accordingly, the invention is not to be considered as being limited by the foregoing description.

## Claims

1. A device (10) comprising:
a first substrate (11) comprising a first side and a second side;
a functional element (12) on the first side of the first substrate (11);
a pad (13) that is electrically connected to the functional element (12); and a through-hole interconnection (15) provided in a hole extending through the first substrate (11) from the first side to the second side, the through-hole interconnection (15) comprising: a first conductive material (17) that is electrically connected to the pad (13); and a conductive region, provided along an inner surface of the hole between said first conductive material (17) and said first substrate (11), comprising a second conductive material different from the first conductive material (17).

2. The device (10) according to claim 1, wherein the conductive region is provided on the pad (13), which defines a bottom of the hole.

3. The device (10) according to claim 2, wherein the conductive region is made of a material that enhances adhesion between the first conductive material (17) and the pad (13).

4. The device (10) according to claim 1, wherein the conductive region is provided on a side wall of the hole.

5. The device (10) according to claim 4, wherein the first conductive material (17) contains at least one element, and the conductive region prevents the at least one element contained in the first conductive material (17) from diffusing to the first substrate (11).

6. The device (10) according to claim 1, wherein the conductive region is provided on; the pad (13), which defines the bottom of the hole; and a side wall of the hole.

7. The device (10) according to claim 6, wherein the conductive region is made of a material that enhances adhesion between the inner wall of the hole and the pad (13).

8. The device (10) according to claim 7, wherein the first conductive material (17) contains at least one element, and the conductive region prevents the at least one element contained in the first conductive material (17) from diffusing to the first substrate (11).

9. The device (10) according to claim 1, wherein a circumference of a region of contact between the through-hole interconnection (15) and the pad (13) is within a circumference of a region of contact between the pad (13) and the first substrate (11).

10. The device (10) according to claim 1, wherein the conductive region includes at least two layers, and the at least two layers are made of different materials.

11. The device (10) according to claim 1, further comprising:
a circuit (14) connecting the functional element (12) and the pad (13).

12. A method for manufacturing a device (10) comprising the steps of:
providing a first substrate (11) comprising a first side and a second side, a functional element (12) being provided on the first side of the first substrate (11), and a pad (13) electrically connected to the functional element (12); and
forming a hole form the second side of the first substrate (11) until the pad (13) is exposed;
forming a conductive region that is made of a second conductive material on at least a portion of an inner surface of the hole, filling the first conductive material (17) in the hole to define a through-hole interconnection (15), wherein the first conductive material (17) is different from the second conductive material.

13. The method for manufacturing a device (10) according to claim 12, further comprising the step of patterning the conductive region made of the second conductive material using a dry film resist.

14. The method of claim 12, further comprising:
providing a circuit (14) connecting the functional element (12) and the pad (13).

15. The device (10) according to claim 1, further comprising:
an insulating dielectric region formed on an inner side wall of said hole between said first conductive material (17) and said first substrate (11); and
wherein said first substrate (11) is formed of a conductive material.

16. The device (10) according to claim 15, wherein:
said insulating dielectric region extends from said hole at said second side of said first substrate (11) and covers a portion of said second side of said first substrate (11);
said conductive region extends from said hole at said second side of said first substrate (11) and covers a portion of said insulating dielectric region which extends from said hole; and
said through-hole interconnection (15) extends from said hole at said second side of said first substrate (11) and covers a portion of said conductive region which extends from said hole.

17. The device (10) according to claim 16, wherein said through-hole interconnection (15) completely covers an end of said conductive region which extends from said hole.

18. The device (10) according to claim 1, further comprising a second substrate which is bonded to a portion of the first side of the first substrate (11).

19. The device (10) according to claim 15, wherein:
said insulating dielectric region extends from said hole at said second side of said first substrate (11) and covers a portion of said second side of said first substrate (11);
a second circuit (14) is provided at an end of said through-hole interconnection (15) at said second side of said first substrate (11);
and a bump is provided on said second circuit (14).

20. The device (10) according to claim 19, wherein said second circuit (14) is a multilayered circuit (14) and the layers of said circuit (14) are interposed by a second insulating layer.

21. The device (10) according to claim 20, wherein said multilayered circuit (14) comprises a two-layered structure and the two layers are connected by a second through-hole interconnection (15) which is formed through said second insulating layer.
